Europäisches Patentamt

European Patent Office

Office européen des brevets

Veröffentlichungsnummer: **0 432 280 A1**

# EUROPÄISCHE PATENTANMELDUNG

Anmeldenummer: 89122306.7

Int. Cl.5 **H03K 19/0175**

Anmeldetag: **04.12.89**

Veröffentlichungstag der Anmeldung:
**19.06.91 Patentblatt 91/25**

Benannte Vertragsstaaten:
**AT BE CH DE ES FR GB GR IT LI LU NL SE**

Anmelder: **Siemens Aktiengesellschaft
Wittelsbacherplatz 2
W-8000 München 2(DE)**

Erfinder: **Kammerl, August, Dipl.-Ing.
Wiesenweg 14
W-8411 Brunn(DE)**
Erfinder: **Niedermeier, Ernst, Dipl.-Ing.
Seedorfer Strasse 3
W-8401 Hohengebraching(DE)**

**Schnittstelle zwischen zwei an unterschiedlichen Betriebsspannungen betriebenen elektrischen Schaltungen.**

Schnittstelle zwischen zwei an unterschiedlichen Betriebsspannungen (UB, UV) betriebenen elektrischen Schaltungen (I, II), wobei der Eingangspegel (UR) der empfangenden Schaltung (II) proportional mit der schwankenden Betriebsspannung (UB) der sendenden Schaltung (I) mitgeführt wird. Das Ausgangssignal (Ue) der sendenden Schaltung (I) wird mit dem Eingangspegel (UR) in einem Komparator verglichen, der aus einem Transistor (T) gebildet ist. Je nach Anschluß des Ausgangssignals (Ue) und des Eingangspegels (UR) an den Transistor (T) entsteht eine invertierende oder nichtinvertierende Schnittstellenschaltung mit wenigen, preiswerten Bauteilen mit geringem Platzbedarf.

FIG 2

EP 0 432 280 A1

## SCHNITTSTELLE ZWISCHEN ZWEI AN UNTERSCHIEDLICHEN BETRIEBSSPANNUNGEN BETRIEBENEN ELEKTRISCHEN SCHALTUNGEN

Die Erfindung betrifft eine Schnittstelle zwischen zwei an unterschiedlichen Betriebsspannungen betriebenen elektrischen Schaltungen gemäß dem Oberbegriff des Anspruchs 1.

Derartige Schnittstellen werden benötigt, wenn Schaltungen mit unterschiedlichen Betriebsspannungen oder unterschiedlichen Signalpegeln miteinander arbeiten sollen, wie es beispielsweise in Kraftfahrzeugen der Fall ist. Dort werden beispielsweise Signale in Schaltungen erzeugt, welche mit der Batteriespannung UB des Bordnetzes betrieben werden und deren Ausgangssignale in weiteren Schaltungen verarbeitet werden, welche an einer anderen Versorgungsspannung UV liegen. Erschwerend dabei ist, daß die Batteriespannung UB und damit die Ausgangspegel der mit ihr betriebenen Schaltungen stark schwanken und mit erheblichen Störsignalen behaftet sein können.

In ungünstigen Fällen ist ein verbesserter Störspannungsabstand zu erreichen, wenn der Eingangspegel der empfangenden Schaltung proportional zur Betriebsspannung der sendenden Schaltung gehalten wird. Dies wird in der Regel dadurch erreicht, daß mit einem Spannungsteiler von der Betriebsspannung der sendenden Schaltung, hier also von der Batteriespannung, eine Referenzspannung UR für einen integrierten Komparator der empfangenden Schaltung gebildet wird, mit welchem das Ausgangssignal der sendenden Schaltung verglichen wird. Das Ausgangssignal des Komparators, der an der Versorgungsspannung der empfangenden Schaltung liegt, ist unabhängig von der Höhe seiner Eingangssignale. Nachteilig an dieser bekannten Lösung ist, daß eine integrierte Schaltung verwendet wird, die sehr kostenintensiv ist und sehr viel Platz benötigt.

Aufgabe der Erfindung ist es deshalb, eine Schaltung der eingangs genannten Art zu schaffen, die keinen integrierten Komparator benötigt und mit geringem Platzbedarf und geringen Materialkosten darstellbar ist.

Diese Aufgabe wird erfindungsgemäß durch die im Kennzeichen des Ansprüches 1 genannten Merkmale gelöst.

Durch diese Lösung ergibt sich eine beträchtliche schaltungstechnische Vereinfachung, ohne auf die vom integrierten Komparator her bekannte Genauigkeit und Flankensteilheit des Ausgangsignals verzichten zu müssen.

Durch einfaches Vertauschen zweier Transistoranschlüsse kann die Schaltung wahlweise als invertierende oder nichtinvertierende Schnittstelle betrieben werden. Durch einfache zusätzliche Maßnahmen zur Begrenzung der Referenzspannung und des Ausgangssignals ist es möglich, die sendende Schaltung mit einer stark schwankenden Batteriespannung zu betreiben, auch wenn diese einmal außerhalb des üblicherweise zulässigen Spannungsbereiches liegen sollte.

Die Erfindung wird anhand der Figuren näher erläutert. Es zeigen:

Figur 1 eine bekannte Schaltung mit einem integrierten Komparator,

Figur 2 eine erfindungsgemäße nichtinvertierende Schaltung, und

Figur 3 eine erfindungsgemäße Schaltung einer invertierenden Schnittstelle.

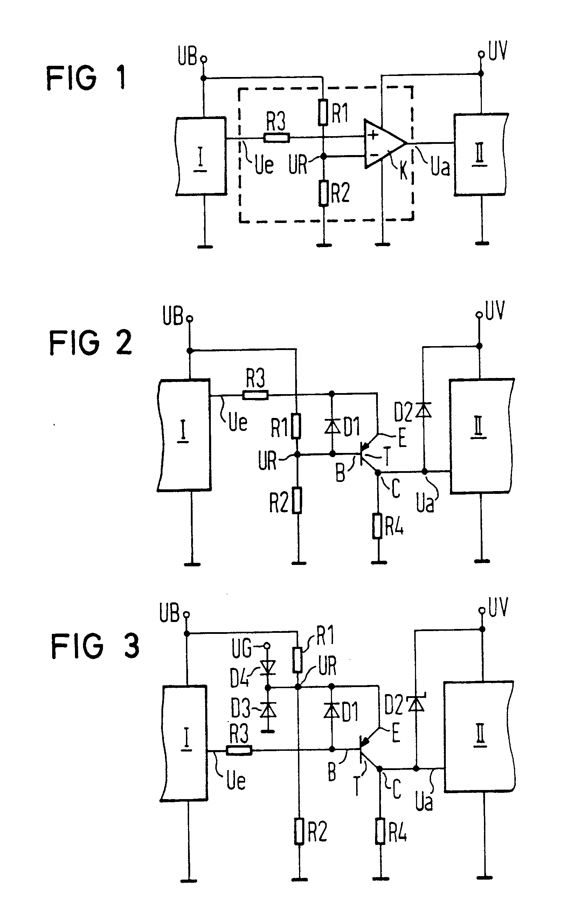

Figur 1 zeigt die bereits erwähnte bekannte Schaltung einer Schnittstelle mit einem integrierten Komparator K. Die strichliert eingerahmte Schnittstelle erhält ihre Eingangssignale Ue, von denen nur eines dargestellt ist, von einer sendenden Schaltung I, welche an der Batteriespannung UB eines Kraftfahrzeugbordnetzes betrieben wird. Dieses Eingangssignal Ue wird in der Schnittstelle zu einem Ausgangssignal Ua umgewandelt, welches an den Eingangspegel einer empfangenden Schaltung II angepaßt ist, welche an einer Versorgungsspannung UV, beispielsweise + 5 V, betrieben wird.

Der Komparator K vergleicht das Eingangssignal Ue, welches über einen Schutzwiderstand R3 seinem nichtinvertierenden Eingang zugeführt wird, mit einer Referenzspannung UR, welche aus der Batteriespannung UB über einen Spannungsteiler aus zwei Widerständen R1 und R2 gewonnen wird und an seinem invertierenden Eingang anliegt. Übersteigt die Eingangsspannung Ue die Referenzspannung UR, so ist das Ausgangssignal Ua des Komparators K ein H-Signal, dessen Spannungswert etwa der Versorgungsspannung UV entspricht, andernfalls ein L-Signal mit etwa 0 V.

Eine derartige Schnittstelle benötigt relativ viel Platz und hohe Bauteilkosten.

Bei den erfindungsgemäßen Schnittstellenschaltungen nach Figur 2 und 3 ist der integrierte Komparator K aus Figur 1 durch einen Transistor T ersetzt, der mit einer Diode D1 und einem Widerstand R4 beschaltet ist.

Figur 2 zeigt die Schaltung einer nichtinvertierenden Schnittstelle, die in der Wirkungsweise der Schaltung nach Figur 1 entspricht. Alle Bauelemente und Spannungen bzw. Signale mit Ausnahme des Transistors T, der Diode D1 und des Widerstandes R4 entsprechen den gleichen Elementen aus Figur 1.

Der Transistor T ist ein pnp-Transistor, an dessen Basis B die Referenzspannung UR liegt. Am Emitter E des Transistors T liegt über den bekannten Schutzwiderstand R3 das Eingangssignal Ue. Zwischen Basis B und Emitter E liegt eine Diode D1 in Durchlaßrichtung zum Emitter E. Am Kollektor C des Transistors T, der über einen Widerstand R4 mit dem Minuspol der Batteriespannung UB verbunden ist, ist das Ausgangssignal Ua abgreifbar. Vom Kollektor C führt eine Diode D2 zum Pluspol der Versorgungs spannung UV, wodurch das Ausgangssignal Ua etwa auf den Wert UV begrenzt wird.

Übersteigt das Eingangssignal Ue die Referenzspannung UR um den Wert der Basis-Emitterspannung des Transistors T, so schaltet dieser durch und am Kollektor C ist das als Spannungsabfall über dem Widerstand R4 erscheinende Ausgangssignal Ua abgreifbar. Andernfalls sperrt der Transistor T und sein Kollektor C liegt auf dem Potential des Minuspols.

In Figur 3 ist die erfindungsgemäße Schaltung als invertierende Schnittstelle dargestellt. Sie entspricht im wesentlichen der Schaltung aus Figur 2 mit dem Unterschied, daß die Anschlüsse von Referenzspannung UR und Eingangssignal Ue an den Transistor T miteinander vertauscht sind. Das heißt, die Referenzspannung UR liegt am Emitter E und das Eingangssignal Ue liegt über den Schutzwiderstand R3 an der Basis B des Transistors T. Dadurch wird erreicht, daß das Ausgangssignal Ua ein H-Signal ist, wenn das Eingangssignal Ue kleiner ist als die Referenzspannung UR, vermindert um die Basis-Emitterspannung des Transistors T. Übersteigt hingegen das Eingangssignal diesen Wert, so ist das Ausgangssignal Ua ein L-Signal, weil dann der Transistor T sperrt und sein Kollektor C auf Minuspotential liegt.

Wie in Figur 2 ist auch hier der Kollektor C über eine Diode D2 mit dem Pluspol der Versorgungsspannung UV der empfangenden Schaltung II verbunden. Diese Diode ist hier als Schottky-Diode dargestellt. Auch sie dient, wie beim Ausführungsbeispiel nach Figur 2, zur Begrenzung des Ausgangssignals Ua.

Zusätzlich ist hier noch eine Reihenschaltung aus zwei Dioden D3 und D4 dargestellt, die zwischen einer einstellbaren Grenzspannung UG und dem Minuspol der Batteriespannung liegt, wobei der Verbindungspunkt der beiden Dioden mit dem Abgriff des Spannungsteilers R1, R2 verbunden ist. Durch diese Zusatzschaltung wird die Referenzspannung UR auf Werte zwischen einem Mindest- und einem Maximalwert begrenzt. Sie kann auch bei der nichtinvertierenden Schaltung nach Figur 2 angewendet werden. In beiden Fällen kann die Diode D3 auch eine Zenerdiode sein. Dadurch ist es auf einfache Weise möglich, die erfindungsgemäße Schnittstelle auch an einer Batteriespannung UB zu betreiben, die, zumindest zeitweise, den zulässigen Spannungsbereich überschreitet.

## Ansprüche

1. Schnittstelle zwischen zwei an unterschiedlichen Betriebsspannungen (UB, UV) betriebenen elektrischen Schaltungen (I, II), mit einem einem Ausgangssignal der ersten Schaltung (I) entsprechenden Eingangssignal (Ue), welches in einem Komparator mit einer zur ersten Betriebsspannung (UB) proportionalen Referenzspannung (UR) verglichen wird, wobei das Ausgangssignal (Ua) des Komparators dem Eingangssignal der zweiten Schaltung (II) entspricht.
**dadurch gekennzeichnet,**
- daß als Komparator ein Transistor (T) vorgesehen ist.
- daß dessen erster Anschluß der Kollektor (C) ist, an welchem das Ausgangssignal (Ua) abgreifbar ist und der über einen Widerstand (R4) mit dem Minuspol der ersten Betriebsspannung (UB) verbunden ist,
- daß dessen zweitem Anschluß die Referenzspannung (UR) zuführbar ist, und
- daß dessen drittem Anschluß das Eingangssignal (Ue) zuführbar ist.

2. Schnittstelle nach Anspruch 1,
**dadurch gekennzeichnet,**
daß bei nichtinvertierendem Betrieb der zweite Anschluß des Transistors (T) dessen Basis (B) und der dritte Anschluß dessen Emitter (E) ist

3. Schnittstelle nach Anspruch 1,
**dadurch gekennzeichnet,**
daß bei invertierendem Betrieb der zweite Anschluß des Transistors (T) dessen Emitter (E) und der dritte Anschluß dessen Basis (B) ist

4. Schnittstelle nach Anspruch 1,
**dadurch gekennzeichnet,**
daß eine Diode (D2) zwischen dem Kollektor (C) und einem Anschlußpunkt mit einem vorgegebenen Spannungswert (UV) liegt.

5. Schnittstelle nach Anspruch 1,
**dadurch gekennzeichnet,**
daß von dem die Referenzspannung (UR) führenden Anschlußpunkt eine Diode (D3) zum Minuspol und eine weitere Diode (D4) zu einem eine einstellbare Grenzspannung (UG) führenden Anschlußpunkt geschaltet ist.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | ELECTRONIC DESIGN, Band 26, Nr. 12, Juni 1978, Seite 146, Rochelle Park, US; S. BARTON: "Quad comparator provides two functions logic-level shifting and time delays" * Figur 2a * | 1-4 | H 03 K 19 0175 |
| Y | GB-A-2 024 551 (IBM) * Figuren 2,3; Seite 2, Zeile 2 - Seite 3, Zeile 16 * | 1,2,4 | |
| A | | 5 | |
| Y | WESCON TECHNICAL PAPERS, 30. Oktober - 2 November 1984, Seiten 1-7, Sektion 28.4, North Hollywood, Anaheim, California, Los Angeles, US; J.G. TORBORG: "High performance display controller operates from single 5V-power supply" * Figur 4; Seite 4, rechte Spalte * | 1,3 | |
| A | DE-C-1 195 986 (THE NATIONAL CASH REGISTER) * Figuren 6,7,2; Spalte 10, Zeilen 3-59 * | 1,2 | |
| A | EP-A-0 340 720 (TOSHIBA) * Figur 3; Spalte 2, Zeile 46 - Spalte 4, Zeile 20 * | 1,2 | RECHERCHIERTE SACHGEBIETE (Int. Cl.5) H 03 K |

Der vorliegende Recherchenbericht wurde für alle Patentansprüche erstellt

| Recherchenort | Abschlußdatum der Recherche | Prüfer |
|---|---|---|
| Den Haag | 03 August 90 | FEUER F.S |